# EUROPEAN PATENT APPLICATION

(11) **EP 3 919 524 A1**
(43) Date of publication of application: **08.12.2021**
(21) Application number: 20747613.6
(22) Date of filing: 29.01.2020
(51) Int. Cl.: C08F 2/48, G03F 7/00, G03F 7/004, G03F 7/033

(54) **WATER-DEVELOPABLE FLEXOGRAPHIC PRINTING ORIGINAL PLATE, FLEXOGRAPHIC PRINTING PLATE AND PHOTOSENSITIVE RESIN COMPOSITION**

(30) Priority: 30.01.2019 JP 2019014480
(71) Applicant: FUJIFILM Corporation, Tokyo 106-8620 (JP)
(72) Inventor: NAMBA Yusuke, Haibara-gun, Shizuoka 421-0396 (JP); FUJIMAKI Kazuhiro, Haibara-gun, Shizuoka 421-0396 (JP); MURAKAMI Taira, Haibara-gun, Shizuoka 421-0396 (JP)
(74) Representative: Hoffmann Eitle
(86) International application number: PCT/JP2020/003102
(87) International publication number: WO 2020/158778

(57) **Abstract**

An object of the present invention is to provide a water-developable flexographic printing plate precursor which has excellent water developability and exhibits excellent printing durability in a case of being made into a flexographic printing plate, a flexographic printing plate, and a photosensitive resin composition. The water-developable flexographic printing plate precursor of the present invention includes a photosensitive layer, in which the photosensitive layer contains a monomer, a polymerization initiator, a base polymer, and water-dispersible particles, the water-dispersible particles have carbon-carbon double bonds, and an amount of the carbon-carbon double bonds on a surface of the water-dispersible particles is 21 or less.

## Description

### BACKGROUND OF THE INVENTION

### 1. Field of the Invention

The present invention relates to a water-developable flexographic printing plate precursor, a flexographic printing plate, and a photosensitive resin composition.

### 2. Description of the Related Art

In recent years, various industries have started to reduce the use of organic solvents from the viewpoint of improving the working environment and preserving the global environment, and in a plate making step of a photosensitive flexographic printing plate used for printing, the use of an aqueous developable photosensitive resin plate is increasing.

For example, WO2013/035535A discloses "a photosensitive flexographic printing plate precursor being developable by water in which at least a support, a photosensitive resin layer containing 25% by mass or more of latex having gelation degree of 55% or more, and an anti-adhesion layer are successively laminated, characterized in that the anti-adhesion layer contains a cellulose derivative" (claim 1).

### SUMMARY OF THE INVENTION

From a study on the water-developable flexographic printing plate precursor disclosed in WO2013/035535A, the present inventors have clarified that, from the viewpoint of improving image reproducibility (hereinafter, abbreviated as "water developability") using an aqueous developer, increasing a mixing ratio of latex has a problem that printing durability in a case of making the water-developable flexographic printing plate precursor into a flexographic printing plate is inferior.

Therefore, an object of the present invention is to provide a water-developable flexographic printing plate precursor which has excellent water developability and exhibits excellent printing durability in a case of being made into a flexographic printing plate, a flexographic printing plate, and a photosensitive resin composition.

As a result of intensive studies to achieve the above-described object, the present inventors have found that a water-developable flexographic printing plate precursor that has a photosensitive layer which contains water-dispersible particles having, on a surface, carbon-carbon double bonds in an amount of a predetermined range together with a monomer, a polymerization initiator, and a base polymer has excellent water developability and exhibits excellent printing durability in a case of being made into a flexographic printing plate, and have completed the present invention.

That is, the present inventors have found that the above-described object can be achieved by adopting the following configurations.

[1] A water-developable flexographic printing plate precursor comprising:
   a photosensitive layer,
   in which the photosensitive layer contains a monomer, a polymerization initiator, a base polymer, and water-dispersible particles,
   the water-dispersible particles have carbon-carbon double bonds, and
   an amount of the carbon-carbon double bonds on a surface of the water-dispersible particles is 21 or less.
[2] The precursor for water-developable flexographic printing according to [1],
   in which a glass transition temperature of a polymer constituting the water-dispersible particles is -52°C or lower.
[3] The precursor for water-developable flexographic printing according to [1] or [2],
   in which the water-dispersible particles are composed of at least one diene-based polymer selected from the group consisting of polybutadiene and a copolymer of an acrylic monomer or a methacrylic monomer with butadiene.
[4] The precursor for water-developable flexographic printing according to [3],
   in which a molar ratio of the butadiene in the copolymer is 80 mol% or more.
[5] A flexographic printing plate comprising:
   an image area; and
   a non-image area,
   in which the image area is an image area obtained by imagewise exposing the photosensitive layer of the precursor for water-developable flexographic printing according to any one of [1] to [4], and developing the exposed photosensitive layer.
[6] A photosensitive resin composition comprising:
   a monomer;
   a polymerization initiator;
   a base polymer; and
   water-dispersible particles,
   in which the water-dispersible particles have carbon-carbon double bonds, and
   an amount of the carbon-carbon double bonds on a surface of the water-dispersible particles is 21 or less.
[7] The photosensitive resin composition according to [6],
   in which a glass transition temperature of a polymer constituting the water-dispersible particles is -52°C or lower.
[8] The photosensitive resin composition according to [6] or [7],
   in which the water-dispersible particles are composed of at least one diene-based polymer selected from the group consisting of polybutadiene and a copolymer of an acrylic monomer or a methacrylic monomer with butadiene.
[9] The photosensitive resin composition according to [8],
   in which a molar ratio of the butadiene in the copolymer is 80 mol% or more.

According to the present invention, it is possible to provide a water-developable flexographic printing plate precursor which has excellent water developability and exhibits excellent printing durability in a case of being made into a flexographic printing plate, a flexographic printing plate, and a photosensitive resin composition.

### DESCRIPTION OF THE PREFERRED EMBODIMENTS

Hereinafter, the present invention will be described in detail.

The description of the constitutional requirements described below may be made on the basis of representative embodiments of the present invention, but it should not be construed that the present invention is limited to those embodiments.

In this specification, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

In addition, in this specification, "(meth)acrylate" represents a notation of "acrylate" or "methacrylate", "(meth)acryl" represents a notation of "acryl" or "methacryl", and "(meth)acryloyl" represents a notation of "acryloyl" or "methacryloyl".

### [Water-developable flexographic printing plate precursor]

A water-developable flexographic printing plate precursor according to an embodiment of the present invention (hereinafter, also abbreviated as a "printing plate precursor according to the embodiment of the present invention") is a water-developable flexographic printing plate precursor including a photosensitive layer.

In addition, the above-described photosensitive layer contains a monomer, a polymerization initiator, a base polymer, and water-dispersible particles.

In addition, the water-dispersible particles have carbon-carbon double bonds, and an amount of the carbon-carbon double bonds on a surface of the water-dispersible particles is 21 or less.

In the present invention, as described above, a printing plate precursor that has a photosensitive layer which contains water-dispersible particles having, on a surface, carbon-carbon double bonds in an amount of a predetermined range together with a monomer, a polymerization initiator, and a base polymer has excellent water developability and exhibits excellent printing durability in a case of being made into a flexographic printing plate.

Although the details thereof are not clear, the present inventors have assumed as follows.

That is, since the amount of the carbon-carbon double bonds on the surface of the water-dispersible particles is 21 or less, a fusion of the water-dispersible particles is suppressed, and as a result, dispersibility of the water-dispersible particles contained in the photosensitive layer is improved. Therefore, it is considered that both excellent developability and printing durability can be achieved.

Hereinafter, the photosensitive layer of the printing plate precursor according to the embodiment of the present invention will be described in detail.

### [Photosensitive layer]

As described above, the photosensitive layer included in the printing plate precursor according to the embodiment of the present invention contains a monomer, a polymerization initiator, a base polymer, and water-dispersible particles.

### <Water-dispersible particles>

The water-dispersible particles contained in the photosensitive layer are not particularly limited as long as the water-dispersible particles have carbon-carbon double bonds, and an amount of the carbon-carbon double bonds on a surface is 21 or less.

Here, the amount of the carbon-carbon double bonds on the surface of the water-dispersible particles (hereinafter, also abbreviated as a "surface C=C amount") is a value measured by the following procedure using an X-ray photoelectron spectroscopy (hereinafter, also abbreviated as "XPS").

First, 100 µL of an aqueous dispersion liquid containing water-dispersible particles is taken, diluted with ultrapure water to approximately 2 mL, and centrifuged to obtain a solid content.

The obtained solid content is redispersed in 80 to 120 µL of ultrapure water, and 1 µL of the redispersion liquid is dropped onto a Si wafer and dried.

Next, the Si wafer is enclosed in a chamber including a bromine aqueous solution so that the Si wafer does not come into direct contact with the bromine aqueous solution, and the carbon-carbon double bonds of the water-dispersible particles are bromine-modified in the gas phase.

After degassing the obtained sample in the vacuum chamber, the amount of surface bromine is analyzed by measuring with XPS. Specifically, peak intensities of elements C and Br are measured by XPS, and the ratio of the obtained peak intensities is corrected by the relative sensitivity coefficient for each element to calculate the amount (atom%) of each element. Among these, the amount (atom%) of Br is defined as the surface C=C amount (a.u.).

In the present invention, the surface C=C amount of the water-dispersible particles is preferably 5 to 20, more preferably 8 to 20, and still more preferably 10 to 20.

In the present invention, from the reason that water dispersibility is improved and printing durability of the obtained flexographic printing plate is further improved, the water-dispersible particles are preferably composed of a polymer.

Specific examples of the above-described polymer include diene-based polymers (for example, polybutadiene, natural rubber, styrene-butadiene copolymer, acrylonitrile-butadiene copolymer, copolymer of (meth)acrylic monomer and butadiene, polychloroprene, and polyisoprene), polyurethane, vinylpyridine polymer, butyl polymer, thiokol polymer, acrylate polymer, and a polymer obtained by copolymerizing these polymers with other components such as acrylic acid and methacrylic acid. These may be used alone or in combination of two or more.

Among these, from the reason that solvent resistance of the obtained flexographic printing plate is good, as the above-described polymer, at least one diene-based polymer selected from the group consisting of polybutadiene and a copolymer of a (meth)acrylic monomer and butadiene is preferable.

Here, examples of the (meth)acrylic monomer include a (meth)acrylic acid derivative such as (meth)acrylic acid, (meth)acrylic acid ester, (meth)acrylamide, and a (meth)acrylamide derivative.

Specific examples of the (meth)acrylic acid derivative include (meth)acrylic acid alkyl esters such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, and octadecyl (meth)acrylate; (meth)acrylic acid cycloalkyl esters such as cyclohexyl (meth)acrylate; and (meth)acrylic acid aryl esters such as phenyl (meth)acrylate. These may be used alone or in combination of two or more.

In the present invention, in a case where the polymer constituting the water-dispersible particles is a copolymer of a (meth)acrylic monomer and butadiene, from the viewpoint of resistance to a solvent, the molar ratio of the butadiene in this copolymer is preferably 80 mol% or more, more preferably 85 mol% or more, and still more preferably 90 mol% or more and less than 100 mol%.

In the present invention, from the reason that stable print quality can be provided by suppressing change in modulus of elasticity during printing (at 25°C or higher) using the obtained flexographic printing plate, the glass transition temperature of the polymer constituting the water-dispersible particles is preferably -52°C or lower.

Here, the glass transition temperature is measured by using a differential scanning calorimeter [manufactured by Seiko Instruments Inc., product name: "DSC-6200"] in accordance with JIS K 7121 (1987) (measuring method of transition temperature of plastic).

First, the flexographic printing plate is dispersed in tetrahydrofuran (THF) so as to be 1.0 mg/mL and filtered through a filter, and then by vacuum-drying the dispersion liquid, insoluble components (components including water-dispersed particles) are collected. For the collected insoluble components, the glass transition temperature is measured by the following procedure.

3 mg of a powder sample of the collected insoluble components is heated (heating rate: 10 °C/min) under a nitrogen atmosphere (gas flow rate: 80 ml/min) and measured twice, and the second data is adopted. In a case where two or more glass transition temperatures are observed, the lowest temperature is defined as the glass transition temperature of the polymer constituting the water-dispersible particles.

In the present invention, from the reason that the surface C=C amount can be easily adjusted, it is preferable that the water-dispersible particles are composed of a polymer obtained by adding a polymerization initiator to an aqueous dispersion liquid (latex) containing the above-described polymer (particularly, the diene-based polymer), heating the mixture to cause a crosslinking reaction, and removing water.

Here, the above-described polymerization initiator may be the same as the polymerization initiator contained in the photosensitive layer, which will be described later, but the above-described polymerization initiator is preferably an azo polymerization initiator and more preferably a water-soluble azo polymerization initiator.

Specific examples of the water-soluble azo polymerization initiator include 2,2'-azobis[2-(2-imidazolin-2-yl)propane] dihydrochloride, 2,2'-azobis[2-(2-imidazolin-2-yl)propane] disulfate/dihydrate, 2,2' -azobis(2-methylpropionamidine) dihydrochloride, 2,2'-azobis[N-(2-carboxyethyl)-2-methylpropionamidine] tetrahydrate, 2,2'-azobis[2-(2-imidazolin-2-yl)propane], 2,2'-azobis[2-methyl-N-(2-hydroxyethyl)propionamide], and 4,4'-azobis(4-cyanovaleric acid). For these examples, commercially available products (VA-044, VA-046B, V-50, VA-057, VA-061, VA-086, and V-501) manufactured by FUJIFILM Wako Chemicals Corporation can be used.

In the present invention, the content of the water-dispersible particles is preferably 10% to 80% by mass, more preferably 20% to 70% by mass, and still more preferably 30% to 60% by mass with respect to the total mass of solid content in the photosensitive layer.

In addition, from the reason that the printing durability of the obtained flexographic printing plate is further improved, the content of the water-dispersible particles is preferably 50 to 400 parts by mass and more preferably 110 to 250 parts by mass with respect to 100 parts by mass of the base polymer described later.

In the present invention, from the reason that it is easy to synthesize particles of homogeneous size, and the like, the average particle size of the water-dispersible particles is preferably 5 to 500 nm and more preferably 50 to 350 nm.

Here, the average particle size refers to a value measured by a dynamic light scattering method using an aqueous dispersion liquid including water-dispersible particles.

### <Monomer>

The monomer contained in the photosensitive layer is not particularly limited, and photopolymerizable monomers used in known flexographic printing plates in the related art can be used.

Examples of the photopolymerizable monomer include ethylenically unsaturated compounds.

The ethylenically unsaturated compound may be a monofunctional ethylenically unsaturated compound or a polyfunctional ethylenically unsaturated compound, but is preferably a polyfunctional ethylenically unsaturated compound.

Suitable examples of the polyfunctional ethylenically unsaturated compound include a compound having 2 to 20 terminal ethylenically unsaturated groups, and specific examples thereof include alkanediol (meth)acrylate compounds such as 1,3-butanediol dimethacrylate, 1,4-butanediol diacrylate, 1,4-butanediol dimethacrylate, 1,6-hexanediol diacrylate, 1,6-hexanediol dimethacrylate, 1,9-nonanediol diacrylate, 1,9-nonanediol dimethacrylate, 1,12-dodecanediol diacrylate, and 1,12-dodecanediol dimethacrylate;
glycol di(meth)acrylate compounds such as ethyleneglycol di(meth)acrylate, diethyleneglycol di(meth)acrylate, triethyleneglycol di(meth)acrylate, tetraethyleneglycol di(meth)acrylate, polyethyleneglycol di(meth)acrylate, propyleneglycol di(meth)acrylate, dipropyleneglycol di(meth)acrylate, tripropyleneglycol di(meth)acrylate, tetrapropyleneglycol di(meth)acrylate, polypropyleneglycol di(meth)acrylate, ethoxylated neopentylglycol di(meth)acrylate, and propoxylated neopentylglycol di(meth)acrylate;
di or trivinyl ether compounds such as ethyleneglycol divinyl ether, diethyleneglycol divinyl ether, triethyleneglycol divinyl ether, propyleneglycol divinyl ether, dipropyleneglycol divinyl ether, butanediol divinyl ether, hexanediol divinyl ether, cyclohexanedimethanol divinyl ether, and trimethylolpropane trivinyl ether;
di(meth)acrylate compounds of bisphenol A such as bisphenol A diglycidyl ether (meth)acrylic acid adduct, modified bisphenol A di(meth)acrylate, bisphenol A PO-adducted di(meth)acrylate, and bisphenol A EO-adducted di(meth)acrylate;
tri or more valent ester compounds of alcohol such as pentaerythritol tri(meth)acrylate, pentaerythritol tetra(meth)acrylate, dipentaerythritol tetra(meth)acrylate, trimethylolethane tri(meth)acrylate, trimethylolpropane tri(meth)acrylate, and tetramethylolmethane tetra(meth)acrylate; allyl compounds such as diallyl phthalate and triallyl trimellitate; and
bis(4-(meth)acryloxypolyethoxyphenyl) propane.
PO represents propylene oxide and EO represents ethylene oxide.

The content of the monomer is preferably 1% to 30% by mass, more preferably 2% to 25% by mass, and still more preferably 5% to 20% by mass with respect to the total mass of solid content in the photosensitive layer.

### <Polymerization initiator>

The polymerization initiator contained in the photosensitive layer is not particularly limited as long as the photopolymerization of the above-described monomer is initiated, and examples thereof include photopolymerization initiators such as alkylphenones, acetophenones, benzoin ethers, benzophenones, thioxanthones, anthraquinones, benzyls, and biacetyls.

Specific examples thereof include benzyl dimethyl ketal, 2-hydroxy-2-methyl-1-phenyl-propane-1-one, methyl-o-benzoylbenzoate, and 1-hydroxycyclohexyl phenyl ketone.

From the viewpoint of sensitivity or the like, the content of the polymerization initiator is preferably 0.3% to 15% by mass and more preferably 0.5% to 10% by mass with respect to the total mass of solid content in the photosensitive layer.

### <Base polymer>

The base polymer contained in the photosensitive layer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that an elastic and flexible film can be easily formed, a rubber or a thermoplastic elastomer is preferable, a rubber is more preferable, and a diene-based rubber is still more preferable.

Specific examples of the rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more. Among these, from the reason that the water developability is improved, or from the viewpoint of drying properties and image reproducibility, at least one rubber selected from the group consisting of butadiene rubber (BR) and nitrile rubber (NBR) is preferable, and butadiene rubber is more preferable.

Examples of the thermoplastic elastomer include a polybutadiene-based thermoplastic elastomer, a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that the water developability is improved, or from the viewpoint of drying properties and image reproducibility, SBS or SIS is particularly preferable.

The content of the base polymer is preferably 1% to 50% by mass, more preferably 5% to 40% by mass, and still more preferably 7% to 30% by mass with respect to the total mass of solid content in the photosensitive layer.

### <Plasticizer>

From the viewpoint of improving flexibility, the photosensitive layer included in the printing plate precursor according to the embodiment of the present invention preferably contains a plasticizer.

Specific examples of the plasticizer include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.

Specific examples of the oil include paraffin, naphthene, and aroma.

Specific examples of the polyester include adipic acid-based polyester.

Specific examples of the phosphoric acid-based compound include phosphoric acid ester.

In a case of containing a plasticizer, the content of the plasticizer is preferably 0.1% to 40% by mass and more preferably 5% to 30% by mass with respect to the total mass of solid content in the photosensitive layer.

### <Surfactant>

From the viewpoint of further improving the water developability, the photosensitive layer included in the printing plate precursor according to the embodiment of the present invention preferably contains a surfactant.

Examples of the surfactant include a cationic surfactant, an anionic surfactant, and a nonionic surfactant. Among these, from the reason that the effects of the present invention are more excellent, an anionic surfactant is preferable.

Specific examples of the anionic surfactant include
aliphatic carboxylates such as sodium laurate, and sodium oleate;
higher alcohol sulfate ester salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

Among these, from the reason that the water developability is further improved, sulfonic acid-based surfactants such as alkyl sulfonate and alkyl allyl sulfonate are preferable.

In a case of containing a surfactant, the content of the surfactant is preferably 0.1% to 20% by mass and more preferably 1% to 10% by mass with respect to the total mass of solid content in the photosensitive layer.

### <Thermal polymerization inhibitor>

From the viewpoint of improving heat stability during kneading and improving storage stability, the photosensitive layer included in the printing plate precursor according to the embodiment of the present invention can contain a thermal polymerization inhibitor (stabilizer).

Examples of the thermal polymerization inhibitor include phenols, hydroquinones, and catechols.

In a case of containing a thermal polymerization inhibitor, the content of the thermal polymerization inhibitor is preferably 0.001% to 5% by mass with respect to the total mass in solid content of the photosensitive layer.

### <Other additives>

To the extent that the effects of the present invention are not impaired, other additives such as an ultraviolet absorber, a dye, a pigment, an anti-foaming agent, and a fragrance can be appropriately added to the photosensitive layer included in the printing plate precursor according to the embodiment of the present invention, for the purpose of improving various properties.

### <Method for producing photosensitive layer>

A method for producing the photosensitive layer included in the printing plate precursor according to the embodiment of the present invention is not particularly limited, and examples thereof include a method of preparing a composition (photosensitive resin composition) containing each of the above-described components and applying the composition to a substrate or the like.

The flexographic printing plate precursor according to the embodiment of the present invention may be a so-called analog type printing plate precursor in which a negative film (film on which an image is already formed) is closely attached to the photosensitive layer at the time of use, or may be a laser ablation mask (LAM) type printing plate precursor, in which an infrared ablation layer is closely attached to the photosensitive layer in advance, the LAM type being included in a so-called computer to plate (CTP) type.

The analog type printing plate precursor is a printing plate precursor in which an adhesive layer composed of an adhesive or the like which adheres the substrate and a photosensitive layer, a photosensitive layer composed of a photosensitive resin composition according to an embodiment of the present invention described later, an anti-adhesion layer to prevent the surface of the photosensitive layer from adhering, and a protective film preventing scratches on the photosensitive resin composition before use are laminated on a substrate in this order.

Specific examples of the substrate include plastic films such as a polyethylene terephthalate (PET) film or plastic sheets; metal sheets such as stainless and aluminum; and rubber sheets such as butadiene rubber.

In the analog type printing plate precursor, the protective film is peeled off at the time of use, and the negative film on which an image is formed in advance is closely attached to the exposed anti-adhesion layer.

The analog type printing plate precursor can be manufactured by, for example, applying an adhesive in advance to one surface of the substrate and applying an anti-adhesion agent in advance to one surface of the protective film, interposing a photosensitive resin composition according to an embodiment of the present invention described later between the substrate to which the adhesive is applied in advance and the protective film to which the anti-adhesion agent is applied in advance, and pressing the printing plate precursor such that the thickness of the photosensitive resin composition is a predetermined thickness.

The LAM type printing plate precursor is different from the analog type printing plate precursor in that the LAM type printing plate precursor has an infrared ablation layer between the photosensitive layer and the protective film, and other configurations are the same as the analog type printing plate precursor. That is, the adhesive layer, the photosensitive layer, the infrared ablation layer, and the protective film are laminated on the substrate in this order. In the LAM type printing plate precursor, the protective film is peeled off at the time of use to expose the infrared ablation layer.

The infrared ablation layer is a layer capable of removing a portion irradiated by an infrared laser, and the infrared ablation layer itself is a layer which also has a function of blocking the transmission of ultraviolet rays at a practical level. By forming an image on the infrared ablation layer, the infrared ablation layer can serve as a negative film or a positive film.

The infrared ablation layer is mainly composed of a binder such as resin and rubber, an infrared absorbing substance, an ultraviolet absorbing substance, a plasticizer, and the like. The infrared ablation layer can be manufactured by, for example, dissolving the above-described materials in a solvent, applying the solution to a base material, and drying the solution to remove the solvent.

The LAM type printing plate precursor can be manufactured by, for example, applying an adhesive in advance to one surface of the substrate and coating one surface of the protective film with an infrared ablation layer in advance, interposing the photosensitive resin composition according to the embodiment of the present invention between the substrate to which the adhesive is applied in advance and the protective film which is coated with the infrared ablation layer in advance, and pressing the printing plate precursor such that the thickness of the photosensitive resin composition is a predetermined thickness.

In any of the printing plate precursors, the thickness of the photosensitive layer is preferably in a range of 0.01 to 10 mm. In a case where the thickness of the photosensitive layer is 0.01 mm or more, a sufficient relief depth can be secured. On the other hand, in a case where the thickness of the photosensitive layer is 10 mm or less, the weight of the printing plate precursor can be suppressed, and the printing plate precursor can be practically used as a printing plate.

### [Flexographic printing plate]

A flexographic printing plate according to an embodiment of the present invention is a flexographic printing plate including an image area and a non-image area.

In addition, the image area included in the flexographic printing plate according to the embodiment of the present invention is an image area obtained by imagewise exposing the photosensitive layer of the printing plate precursor according to the embodiment of the present invention, and developing the exposed photosensitive layer.

In order to form a relief image on the photosensitive layer of the printing plate precursor, first, ultraviolet irradiation is performed on the substrate side of the printing plate precursor (back exposure).

In a case of using the analog type printing plate precursor, the protective film is peeled off, and the negative film on which an image is formed in advance is closely attached to the exposed anti-adhesion layer. On the other hand, in a case of using the LAM type printing plate precursor, the protective film is peeled off, and a desired image is formed by, for example, irradiating the exposed infrared ablation layer with an infrared laser.

Next, the photosensitive layer is cured by irradiating ultraviolet rays from above the negative film or the infrared ablation layer (main exposure). The ultraviolet rays can be usually irradiated from a high-pressure mercury lamp, an ultrahigh-pressure mercury lamp, a metal halide lamp, a xenon lamp, a carbon arc lamp, a chemical lamp, and the like, which can perform irradiation with light having a wavelength of 300 to 400 nm. An irradiated portion of the photosensitive layer is cured by irradiation with ultraviolet rays. The photosensitive layer covered with the negative film or the infrared ablation layer has a cured portion irradiated with ultraviolet rays and an uncured portion not irradiated with ultraviolet rays.

Next, the relief image is formed by removing the uncured portion of the photosensitive layer in the developer. As the developer, an aqueous developer is used. The aqueous developer is composed of water to which a surfactant, pH adjuster, or the like is added as necessary. The uncured portion of the photosensitive layer can be removed by, for example, washing out the uncured portion using a spray type developing device or a brush type washing machine.

Next, the printing plate material is taken out from the developer and dried. Next, the entire dried printing plate material is irradiated with ultraviolet rays as necessary (post exposure). As a result, a flexographic printing plate is obtained.

### [Photosensitive resin composition]

A photosensitive resin composition according to an embodiment of the present invention is a photosensitive resin composition including a monomer, a polymerization initiator, a base polymer, and water-dispersible particles, in which the water-dispersible particles have carbon-carbon double bonds, and an amount of the carbon-carbon double bonds on a surface of the water-dispersible particles is 21 or less.

In addition, the photosensitive resin composition according to the embodiment of the present invention may contain a plasticizer, a surfactant, a thermal polymerization inhibitor, and other additives.

Here, the monomer, the polymerization initiator, the base polymer, the water-dispersible particles, the plasticizer, the surfactant, the thermal polymerization inhibitor, and other additives are the same as those described in the printing plate precursor according to the embodiment of the present invention, respectively.

In addition, with regard to the content of these components, the "total mass of solid content in the photosensitive layer" described in the printing plate precursor according to the embodiment of the present invention can be read as "total mass of solid content in the photosensitive resin composition" and applied.

### Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

### [Preparation of synthetic latex 1]

465.0 g of water-dispersed latex (manufactured by Zeon Corporation, Nipol LX111NF, water-dispersed latex of polybutadiene, solid content: 55%) and 327.5 g of distilled water were added to a 1L three-neck flask, and the temperature was raised to 75°C with stirring under a nitrogen stream. After 30 minutes, an aqueous solution in which 4.9 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 1 having a concentration of solid contents of 30% by mass.

### [Preparation of synthetic latex 2]

465.0 g of water-dispersed latex (manufactured by Zeon Corporation, Nipol LX111NF, water-dispersed latex of polybutadiene, solid content: 55%) and 327.5 g of distilled water were added to a 1L three-neck flask, and the temperature was raised to 75°C with stirring under a nitrogen stream. After 30 minutes, an aqueous solution in which 4.9 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the temperature was raised to 90°C, and after another 3 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 2 having a concentration of solid contents of 30% by mass.

### [Preparation of synthetic latex 3]

465.0 g of water-dispersed latex (manufactured by Zeon Corporation, Nipol LX111NF, water-dispersed latex of polybutadiene, solid content: 55%) and 327.5 g of distilled water were added to a 1L three-neck flask, and the temperature was raised to 75°C with stirring under a nitrogen stream. After 30 minutes, an aqueous solution in which 4.9 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the temperature was raised to 90°C, and after another 6 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 3 having a concentration of solid contents of 30% by mass.

### [Preparation of synthetic latex 4]

465.0 g of water-dispersed latex (manufactured by Zeon Corporation, Nipol LX111NF, water-dispersed latex of polybutadiene, solid content: 55%) and 327.5 g of distilled water were added to a 1L three-neck flask, and the temperature was raised to 75°C with stirring under a nitrogen stream. After 30 minutes, an aqueous solution in which 9.6 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the temperature was raised to 90°C, and after another 6 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 4 having a concentration of solid contents of 30% by mass.

### [Preparation of synthetic latex 5]

### <Preparation of polybutadiene latex A>

In a pressure-resistant polymerizer, 200 parts by mass of deionized water, 0.03 parts by mass of tripotassium phosphate, 0.002 parts by mass of disodium ethylenediamine tetraacetate, 0.001 parts by mass of ferrous sulfate heptahydrate, and 2.00 parts by mass of sodium dodecylbenzenesulfonate were charged, and after sufficient nitrogen substitution with stirring to remove oxygen, 100 parts by mass of butadiene was added into the system and the temperature was raised to 50°C.

Thereafter, 0.03 parts by mass of cumene hydroperoxide and then 0.10 parts by mass of sodium formaldehyde sulfoxylate were added to the system, and the reaction was performed for 5 hours.

Thereafter, 160 parts by mass of additional butadiene was added to the system.

Thereafter, 0.02 parts by mass of cumene hydroperoxide and then 0.10 parts by mass of sodium formaldehyde sulfoxylate were added to the system, and the reaction was performed for 10 hours.

The residual monomer was devolatilized and removed under reduced pressure to complete the polymerization, thereby obtaining a polybutadiene latex A containing polybutadiene as a main component and having a concentration of solid contents of 55% by mass.

### <Preparation of synthetic latex 5>

465.0 g of the polybutadiene latex A prepared above and 327.5 g of distilled water were added to a 1L three-neck flask, and the temperature was raised to 75°C with stirring under a nitrogen stream. After 30 minutes, an aqueous solution in which 4.9 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the temperature was raised to 90°C, and after another 6 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 5 having a concentration of solid contents of 30% by mass.

### [Preparation of synthetic latex 6]

511.5 g of SB latex (manufactured by Asahi Kasei Co., Ltd., A-7137, water-dispersed latex of styrene-butadiene copolymer, solid content: 50% by mass) and 327.5 g of distilled water were added to a 1L three-neck flask, and the temperature was raised to 75°C with stirring under a nitrogen stream. After 30 minutes, an aqueous solution in which 4.9 g of 2,2'-azobis[N-(2-carboxyethyl)-2-methylpropionamidine] tetrahydrate (VA-057, manufactured by FUJIFILM Wako Chemicals Corporation) as a water-soluble azo polymerization initiator had been dissolved in 65.0 g of distilled water was added thereto at once. After 3 hours, the temperature was raised to 90°C, and after another 6 hours, the mixture was allowed to cool to room temperature (23°C).

Next, the mixture was filtered through a non-woven filter paper (T-270, manufactured by ADVANTEC Co., Ltd.) to remove aggregates, thereby preparing a synthetic latex 6 having a concentration of solid contents of 30% by mass.

A part of the solid content (water-dispersible particles) contained in the prepared synthetic latex 1 to 6 and water-dispersed latex (manufactured by Zeon Corporation, Nipol LX111NF) was collected, and the surface C=C amount and the glass transition temperature were measured by the methods described above. The results are shown in Table 1 below.

**[Table 1]**

| | Water-dispersible particle | |
|---|---|---|
| | Surface C=C amount | Glass transition temperature |
| Synthetic latex 1 | 21.0 | -60°C |
| Synthetic latex 2 | 20.7 | -60°C |
| Synthetic latex 3 | 20.3 | -58°C |
| Synthetic latex 4 | 20.0 | -58°C |
| Synthetic latex 5 | 20.0 | -58°C |
| Synthetic latex 6 | 19.2 | -50°C |
| Nipol LX111NF | 21.4 | -62°C |

### [Example 1]

### [Preparation of photosensitive resin composition]

183 parts by mass of the above-described synthetic latex 1 (solid content: 55 parts by mass) and 15 parts by mass of 1,9-nonanediol dimethacrylate (NK ESTER NOD-N, manufactured by Shin-Nakamura Chemical Co., Ltd.) were mixed, and moisture was evaporated for 6 hours in a dryer heated to 60°C to obtain a mixture of water-dispersible particles and monomers.

The obtained mixture and 25 parts by mass of butadiene rubber [ASADENE (registered trademark) NF35R, manufactured by Asahi Kasei Co., Ltd.) were kneaded in a kneader set at 110°C for 45 minutes.

Thereafter, 0.2 parts by mass of a thermal polymerization inhibitor and 4.8 parts by mass of a photopolymerization initiator Irgacure 651 (manufactured by BASF) were put into the kneader, and the mixture was kneaded for 5 minutes to obtain a photosensitive resin composition.

### [Production of laminate for infrared ablation layer]

812 parts by mass of methyl isobutyl ketone was added to a mixture of 50 parts by mass of acrylic resin (Hi-pearl M-5000, manufactured by Negami Chemical Industrial Co., Ltd.), 50 parts by mass of an elastomer (Nipol DN-101, manufactured by Zeon Corporation), and 100 parts by mass of carbon black (MA-8, manufactured by Mitsubishi Chemical Corporation), and the mixture was mixed by stirring with blade.

After dispersing the obtained mixed solution with a paint shaker, methyl isobutyl ketone was further added thereto so that the solid content was 15% by mass to obtain a polymer/carbon black dispersion liquid (coating solution for an infrared ablation layer).

Next, the coating solution for an infrared ablation layer was applied to one side of a PET film (cover film) having a thickness of 75 µm using a bar coater so that the thickness after drying was 1.0 µm. Thereafter, by drying the film in an oven set at 140°C for 5 minutes, a laminate (laminate for an infrared ablation layer) in which an infrared ablation layer was formed on the cover film was produced.

### [Production of flexographic printing plate precursor]

An adhesive was applied to one side of a PET film (substrate) having a thickness of 125 µm to form an adhesive layer on the substrate. The photosensitive resin composition prepared as described above was sandwiched between the above-described adhesive layer and the infrared ablation layer of the laminate for an infrared ablation layer produced as described above, and the laminate was pressed with a press machine heated to 80°C so that the thickness of the layer (photosensitive layer) of the photosensitive resin composition was 1.14 mm, thereby producing a flexographic printing plate precursor including the substrate, the adhesive layer, the photosensitive layer, the infrared ablation layer, and the protective film in this order.

### [Examples 2 to 7 and Comparative Examples 1 and 2]

A flexographic printing plate precursor was produced in the same manner as in Example 1, except that composition of the photosensitive resin composition was changed to the composition shown in Table 2.

### [Evaluation]

With regard to the produced flexographic printing plate precursor, the following evaluations were performed.

### <Water developability>

The cover film of the produced flexographic printing plate precursor was peeled off, and the produced flexographic printing plate precursor was exposed with an exposure device in which 15 40 W chemical lamps were arranged for 2 seconds from the substrate side from a distance of 15 cm (back exposure). Thereafter, development was performed for 3 minutes in a brush-type washing machine (liquid temperature: 50°C) containing an aqueous developer in which the concentration of detergent (additive-free dishwashing soap, manufactured by MIYOSHI SOAP CORPORATION) was adjusted to 0.5%. Thereafter, the obtained flexographic printing plate was dried with hot air of 60°C until the moisture was removed.

The thickness of the obtained flexographic printing plate was measured using a constant pressure thickness measuring device, and the change in film thickness per minute (development speed) was calculated from the change in thickness before and after development. The evaluation was performed according to the following standards. The results are shown in Table 2 below. Practically, it is preferable that the evaluation is B or higher.

### (Evaluation standard)

A: development speed was 170 µm/min or more.
B: development speed was 100 µm/min or more and less than 170 µm/min.
C: development speed was less than 100 µm/min.

### <Printing durability>

The cover film of the produced flexographic printing plate precursor was peeled off, and the produced flexographic printing plate precursor was exposed with an exposure device in which 15 40 W chemical lamps were arranged for 15 seconds from the substrate side from a distance of 15 cm (back exposure). Thereafter, a negative pattern was formed on the infrared ablation layer using CDI Spark 2120 manufactured by ESKO. Thereafter, the produced flexographic printing plate precursor was exposed with the above-described exposure device for 8 minutes from the infrared ablation layer side from a distance of 15 cm (main exposure). Thereafter, development was performed for 10 minutes in a brush-type washing machine (liquid temperature: 50°C) containing an aqueous developer in which the concentration of detergent (additive-free dishwashing soap, manufactured by MIYOSHI SOAP CORPORATION) was adjusted to 0.5%. Thereafter, the obtained flexographic printing plate was dried with hot air of 60°C until the moisture was removed. Thereafter, the produced flexographic printing plate precursor was exposed with the above-described exposure device for 8 minutes from the photosensitive layer side from a distance of 15 cm (post exposure).

In this way, a flexographic printing plate was produced.

The image area of the produced flexographic printing plate was rubbed 4 times using a continuous load-type scratch resistance strength tester (HEIDON TYPE: 18) and using a cotton waste cloth as a rubbing member under conditions of a load of 500 g and a reciprocating speed of 100 mm/min. For 10 independent dots with a diameter of 500 µm, which had been specified before the rubbing test, whether or not the independent dots were chipped or broken after the rubbing test was evaluated according to the following standard.

The results are shown in Table 2 below. Practically, it is preferable that the evaluation is B or higher.

### (Evaluation standard)

A: none of the 10 independent dots were chipped or broken.
B: 1 or 2 of the 10 independent dots were chipped or broken.
C: 3 or more of the 10 independent dots were chipped or broken.

### <Solvent resistance>

The flexographic printing plate produced for the evaluation of printing durability was immersed in a solution containing 1-propanol (85% by mass) and ethyl acetate (15% by mass) at 25°C for 24 hours, and the mass increase ratio (weight swelling ratio) was measured. The results are shown in Table 2 below. Practically, it is preferable that the evaluation is B or higher.

### (Evaluation standard)

A: mass increase ratio was less than 10%.
B: mass increase ratio was 10% or more and less than 20%.
C: mass increase ratio was 20% or more.

**[Table 2]**

| | Composition of photosensitive layer (photosensitive resin composition) | | | | | | | | Performance evaluation | | |
|---|---|---|---|---|---|---|---|---|---|---|---|
| | Synthetic latex | | Monomer | | Base rubber | | Polymerization initiator | | Water develop ability | Printing durability | Solvent resistance |
| | Type | Part by mass | Type | Part by mass | Type | Part by mass | Type | Part by mass | | | |
| Example 1 | Synthetic latex 1 | 55 | NK ESTER NOD-N | 15 | NF35R | 25 | Irgacure 651 | 4.8 | B | B | A |
| Example 2 | Synthetic latex 2 | 55 | NK ESTER NOD-N | 15 | NF35R | 25 | Irgacure 651 | 4.8 | B | B | A |
| Example 3 | Synthetic latex 3 | 55 | NK ESTER NOD-N | 15 | NF35R | 25 | Irgacure 651 | 4.8 | A | B | A |
| Example 4 | Synthetic latex 4 | 55 | NK ESTER NOD-N | 15 | NF35R | 25 | Irgacure 651 | 4.8 | A | B | A |
| Example 5 | Synthetic latex 5 | 55 | NK ESTER NOD-N | 15 | NF35R | 25 | Irgacure 651 | 4.8 | A | B | A |
| Example 6 | Synthetic latex 6 | 55 | NK ESTER NOD-N | 15 | NF35R | 25 | Irgacure 651 | 4.8 | A | B | B |
| Example 7 | Synthetic latex 4 | 45 | NK ESTER NOD-N | 15 | NF35R | 35 | Irgacure 651 | 4.8 | B | A | A |
| Comparative example 1 | Nipol LX111NF | 55 | NK ESTER NOD-N | 15 | NF35R | 25 | Irgacure 651 | 4.8 | c | B | A |
| Comparative example 2 | Nipol LX111NF | 65 | NK ESTER NOD-N | 15 | NF35R | 15 | Irgacure 651 | 4.8 | B | c | A |

As shown in Tables 1 and 2, in a case where the water-dispersed latex (manufactured by Zeon Corporation, Nipol LX111NF) which contained water-dispersible particles having a surface C=C amount larger than 21, it was found that the water developability was inferior (Comparative Example 1).

In addition, in a case where the blending amount of the water-dispersed latex (manufactured by Zeon Corporation, Nipol LX111NF) was increased, it was found that, although the water developability was improved, the printing durability in a case of being made into a flexographic printing plate was inferior (Comparative Example 2).

On the other hand, in a case where the synthetic latex which contained water-dispersible particles having a surface C=C amount of 21 or less is used, it was found that the water developability was excellent and the printing durability in a case of being made into a flexographic printing plate was also good (Examples 1 to 7).

In addition, from the comparison between Examples 1 to 5 and Example 6, in a case where the glass transition temperature of the polymer constituting the water-dispersible particles in a single film was -52°C or lower, it was found that the solvent resistance in a case of being made into a flexographic printing plate was good.

## Claims

1. A water-developable flexographic printing plate precursor comprising:
a photosensitive layer,
wherein the photosensitive layer contains a monomer, a polymerization initiator, a base polymer, and water-dispersible particles,
the water-dispersible particles have carbon-carbon double bonds, and
an amount of the carbon-carbon double bonds on a surface of the water-dispersible particles is 21 or less.

2. The precursor for water-developable flexographic printing according to claim 1,
wherein a glass transition temperature of a polymer constituting the water-dispersible particles is -52°C or lower.

3. The precursor for water-developable flexographic printing according to claim 1 or 2,
wherein the water-dispersible particles are composed of at least one diene-based polymer selected from the group consisting of polybutadiene and a copolymer of an acrylic monomer or a methacrylic monomer with butadiene.

4. The precursor for water-developable flexographic printing according to claim 3,
wherein a molar ratio of the butadiene in the copolymer is 80 mol% or more.

5. A flexographic printing plate comprising:
an image area; and
a non-image area,
wherein the image area is an image area obtained by imagewise exposing the photosensitive layer of the precursor for water-developable flexographic printing according to any one of claims 1 to 4, and developing the exposed photosensitive layer.

6. A photosensitive resin composition comprising:
a monomer;
a polymerization initiator;
a base polymer; and
water-dispersible particles,
wherein the water-dispersible particles have carbon-carbon double bonds, and
an amount of the carbon-carbon double bonds on a surface of the water-dispersible particles is 21 or less.

7. The photosensitive resin composition according to claim 6,
wherein a glass transition temperature of a polymer constituting the water-dispersible particles is -52°C or lower.

8. The photosensitive resin composition according to claim 6 or 7,
wherein the water-dispersible particles are composed of at least one diene-based polymer selected from the group consisting of polybutadiene and a copolymer of an acrylic monomer or a methacrylic monomer with butadiene.

9. The photosensitive resin composition according to claim 8,
wherein a molar ratio of the butadiene in the copolymer is 80 mol% or more.
